# EUROPEAN PATENT APPLICATION

(11) **EP 1 605 512 A2**
(43) Date of publication of application: **14.12.2005**
(21) Application number: 05104718.1
(22) Date of filing: 01.06.2005
(51) Int. Cl.: H01L 27/142

(54) **Photovoltaic cell with protection device**

(30) Priority: 04.06.2004 IT MI20041128
(71) Applicant: CESI Centro Elettrotecnico Sperimentale Italiano Giacinto Motta S.P.A., 20134 Milano (IT)
(72) Inventor: Campesato, Roberta, 20134, MILANO (MI) (IT)
(74) Representative: Maccalli, Marco

(57) **Abstract**

A photovoltaic cell, in particular a solar cell, includes a first (**125i**) and a second terminal (**125o**) and, between said first and second terminals, at least one photovoltaic conversion unit (**105**) and a protection device (**110**, **120**) of the photovoltaic conversion unit. The protection device includes a conductive path (**110**) in bypass to the photovoltaic conversion unit and an activation device of the conductive path. The activation device includes at least one controlled device (**120**; **300**), adapted to establish a current path in bypass between the first and second terminals through the conductive path in bypass; the controlled device is responsive to an control signal indicative of an operating condition of the photovoltaic conversion unit, particularly a voltage value between said first and second terminals.

## Description

The present invention generally relates to the field of the photovoltaic cells, particularly to photovoltaic cells for solar radiation (shortly, solar cells), and in particular, but not limitatively, to solar cells for use in space applications, for example on board of satellites.

Solar cells are electronic devices capable of converting, with high efficiency, the solar radiation incident thereon.

Solar cells can be of the single *PN* junction type (shortly, single-junction cells), or they may include more than one *PN* or *NP* junctions, in this case they are referred to as multi-junction cells.

Single-junction solar cells are essentially formed by a single *PN* junction, that alone converts a certain spectral range of the solar radiation.

On the contrary, multi-junction solar cells are formed superposing several *PN* or *NP* junctions, presently up to three junctions. The different junctions are formed in different semiconductor materials, and, from the electrical viewpoint, they are connected to each other in series, through tunnel diodes interposed between each pair of adjacent junctions. Each one of the different superposed junctions forms a so-called elementary cell, and the different elementary cells are able to individually convert the different parts of the spectrum of the incident solar radiation, more efficiently than a single junction.

Multi-junction cells have the advantage of being able to generate an output voltage higher compared to single-junction cells, the overall voltage being equal to the sum of the voltages of the individual elementary cells (minus a small voltage drop across the tunnel diodes that connect the cells in series).

From the manufacturing viewpoint, the various material layers intended to form the junction(s) are typically obtained by techniques of epitaxial growth through deposition (for example, through the Metal Organic Chemical Vapour Deposition or MOCVD technique), on commercially available substrates of germanium (Ge), silicon (Si) or gallium arsenide (GaAs).

In particular, during the last years there has been a progressive increase of the performances of the solar cells based on compounds of elements of the III and V groups of the periodic table of the elements (the so-called III-V compounds), and in particular of the GaAs solar cells.

A solar panel, for example of the type intended to power a satellite, includes a plurality of solar cells (be they single-junction cells or multi-junction cells), arranged in groups electrically connected in series, in order to form strings of cells that are capable of supplying the voltage necessary to the operation of the satellite (such a voltage can range from 24V to more than 100V, depending on the type of satellite); such strings are connected in parallel each other.

In operation, it may happen that a portion of the solar panel, and therefore a portion of the cells of a determined string, is in shadow, i.e. it is not illuminated by the solar radiation; for example, this can take place due to the shadowing effect by the antennas of the satellite, or upon exiting from a sun eclipse situation. When some cells in a string of solar cells connected in series are in shadow, the current produced by the illuminated cells forces the cells in shadow to be brought into reverse biasing conditions, and in particular into conditions of so-called "breakdown", so as to withstand the current flow.

Therefore, the solar cells that make up the panel should be able to withstand and resist to the reverse biasing without damaging.

However, the operation in reverse biasing conditions is not congenial to the solar cells, which may easily be damaged, for example in consequence of the phenomenon known as "hot spot": at high voltages, typically before the avalanche multiplication phenomenon is triggered, some points of the cell (called "defects") start conducting the reverse current that is forced by the other (illuminated) cells of the string. Since the area in which the current flows is extremely limited, the resulting current density is very high; by Joule effect, the material suffers a strong local heating, up to melt down and accordingly generate short-circuit paths (called "shunts"). Such paths are irreversible, thus also when the cell returns to be illuminated, the shunts remain, and the solar panel looses efficiency.

Multi-junction solar cells are more prone to being damaged than single-junction cells: the presence of several junctions in series makes the reverse voltages of these cells higher (typically, greater than 20V), and the power dissipated by Joule effect is significant.

A known solution to the problem for guaranteeing the integrity of the solar panel consists in verifying the capability of the individual solar cells to withstand reverse-bias operating conditions. By means of suitable "screening" techniques, the cells that are not capable of withstanding such operating conditions are detected and discarded *a priori.*

However, this solution involves non-negligible disadvantages. First of all, such a methodology can not be applied to multi-junction cells, which, being characterized by very high reverse voltages, would result all to be discarded, because they would be damaged during the screening. In any case, even considering single-junction cells, the necessity of discarding the unsuitable cells involves a decrease of the production yield, with a resulting increase of the cell cost; the Applicant has in fact observed that over 5% of the cells does not pass the test and accordingly results to be discarded.

It is also to be kept in mind that a solar cell in shadow introduces a loss in the total voltage of the string of cells (with respect to the normal operating conditions, in which all of the cells are properly illuminated), and such voltage loss is given by the sum of the missing contribute to the total voltage by the cell in shadow, and of the reverse voltage that develops across such cell (such a voltage is of about 5-6V).

An alternative solution proposes the adoption of protection criteria in respect of the individual cells of the panel against the possible damaging by reverse-biased operation, through the connection of a bypass diode; this diode is connected to the cell with polarity inverted compared to that of the cell, and the current of the string flows therein when the cell under consideration is in shadow.

In particular, since the '70s, according to a solution known in the literature (see, for example, Rauschenbach, "Solar Cell Array Design Handbook", Van Nostrand Reinhold Company, 1980, page. 300 and subsequent.), the bypass diode associated with a certain cell of the panel may be of the so-called "integral" type, formed of a portion of the adjacent cell.

Alternatively, the bypass diode may be a discrete component, generally a silicon diode, external to the cell and properly connected thereto through two connectors.

A further possibility is constituted by a bypass diode of monolithic type, realized using some material layers already present in the structure of the solar cell, or growing some *ad hoc* material layers on the cell structure. This technique is for example disclosed in the international application WO 99/62125.

Although preferable with respect to the solution that proposes the screening of the cells, also the solution that provides for the association of a bypass diode to the cell is not free of problems.

In particular, the use of integral diodes poses at least two different problems: the diode obtained using the solar cell has not suitable electric characteristics, and the connection of the diode to the adjacent cell requires a further connector. Moreover, in addition to the missing contribution of the cells in shadow, the integral diode determines a further loss in the total voltage of the string, equal to the threshold voltage of the diode itself, typically ranging from 2.5V to 3.8V for each cell in shadow.

The use of discrete diodes allows overcoming many of the above mentioned problems, but it implies technical and manufacturing problems that make this solution not convenient from a productive viewpoint; in particular, it does not result appreciated by the panel manufacturers, who purchase the solar cells to integrate them on the panels; the cause of non-satisfaction is mainly the fact that it is necessary to handle components that have an annexed connector, for the connection of the cell to the diode, which connector could be deformed during the manufacturing, for example during the process of attachment of the cell onto the panel. Finally, from the cell manufacturer viewpoint, this solution requires further apparatuses for the soldering of the diodes to the respective connectors on the cells, in addition to the necessity of obtaining the diodes themselves, with resulting problems of increase of the cell final cost. Moreover, also in this case, in addition to the missing contribution of the cells in shadow, the discrete diode determines a loss in the total voltage of the string equal to the threshold voltage of the diode itself, equal to about of 1V for each cell in shadow.

The use of monolithic diodes appears the better solution among those known in the art, although the integration of the diode on board of the cell statistically involves a discard of at least 5% of cells, due to the diode malfunctioning, and an increased complexity in the manufacturing of the device as a whole. Moreover, in addition to the missing contribution of the cells in shadow, the monolithic diode determines a non-negligible loss in the total voltage of the string, since its threshold voltage is typically about of 2V for each cell in shadow.

In view of state of art outlined in the foregoing, an object of the present invention is that of providing a photovoltaic cell capable of withstanding without damages the operation in conditions of reverse biasing, typical for example of the space applications.

In particular, it is an object of the present invention to provide a photovoltaic cell with a protection device that does not exhibit the problems of the known solutions, in particular from the viewpoint of the production costs, of the easiness of handling and of packaging, and of the losses in terms of total voltage when, for example, the cell is mounted in a string to form a panel.

According to an aspect of the present invention, these and other objects are achieved by means of a photovoltaic cell as set forth in the appended claim 1.

Shortly, the photovoltaic cell includes, between a first and a second terminal, at least one photovoltaic conversion unit, and a corresponding protection device including a conductive path bypassing the photovoltaic conversion unit, with an activation device of the conductive path.

The activation device includes at least one controlled device adapted to establish a bypass current path between said first and second terminals, through the bypass conductive path, for example a current switch or a breaker. The controlled device is responsive to a control signal indicative of an operating condition of the photovoltaic conversion unit, for example of a voltage value between the first and the second terminal.

Further aspects of the invention relate to a photovoltaic conversion structure, a solar panel, as well as to a method of protection of a photovoltaic conversion unit.

The features and advantages of the present invention will be made apparent by the following detailed description of an embodiment thereof, given purely by way of a non-limitative example, description that will be carried out in conjunction with the accompanying drawings, wherein:
**Figures 1A** and **1B** show the circuit scheme of principle of a photovoltaic cell with protection device according to an embodiment of the present invention;
**Figure 2** is a circuit scheme of a plurality of cells of the type shown in **Figures 1A** and **1B,** connected in series, for example to form a string of cells of a solar panel;
**Figure 3** is a more detailed circuit scheme of a cell with protection device according to an embodiment of the present invention; and
**Figure 4** is a schematic view in cross-section of a possible practical embodiment of the cell of **Figure 3.**

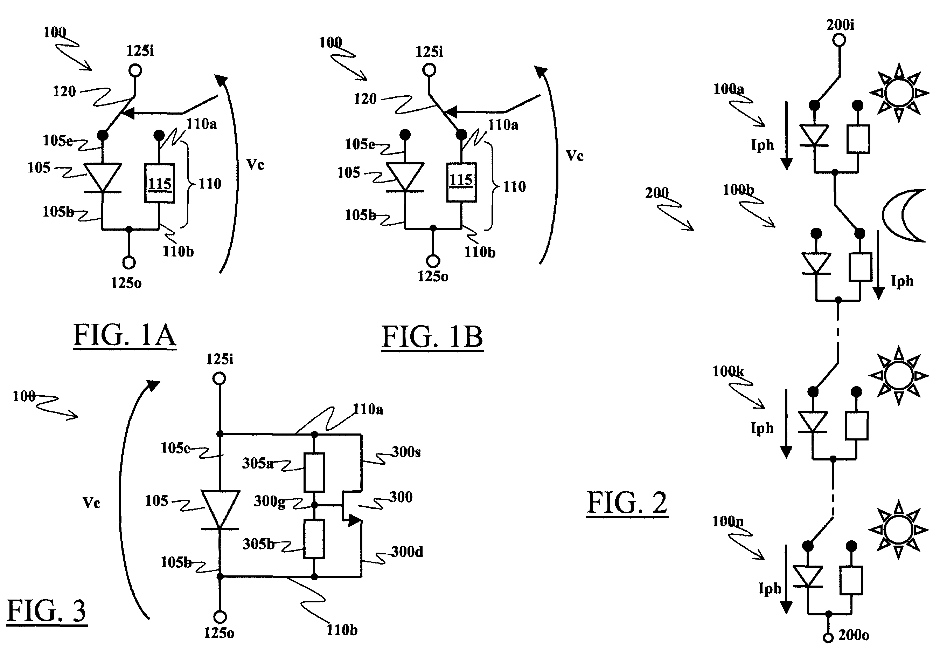

With reference to drawings, and in particular to **Figures 1A** and **1B,** a circuit scheme of principle of a photovoltaic cell with protection device according to a possible embodiment of the present invention is shown.

In particular, the cell with protection device, indicated as a whole with **100,** includes a photovoltaic conversion unit, represented by convention by way of a diode **105**, having a so-called base terminal **105b** and a so-called emitter terminal **105c**. The photovoltaic conversion unit **105** can indifferently be a single-junction cell or a *PN* or *NP* multi-junction cell, in particular in Ge, Si, GaAs, or other known materials, such as InGaAs, InGaP (the number of junctions and the materials used for realizing the junctions are not limitative for the present invention).

The cell with protection device **100** further includes a bypass conductive path 110; the bypass conductive path is characterized by a respective impedance (for example, a certain resistance, possibly due to the inevitable presence of parasitic components), represented in the drawing by a lumped electric component **115.** The bypass path **110** includes a first terminal **110a** and a second terminal **110b.**

A controlled device **120,** for example a current switch, allows connecting to a first terminal, or input terminal **125i** of the cell with protection device **100**, in a selective way, the emitter terminal **105e** of the photovoltaic conversion unit **105** or the first terminal **110a** of the bypass path **110.**

The second terminal **110b** of the bypass conductive path **110** is electrically coupled, in particular connected to the base terminal **105b** of the photovoltaic conversion unit **105.** The base terminal **105b** of the photovoltaic conversion unit **105** and the second terminal **110b** of the bypass path **110** are both electrically connected to a second terminal, or output terminal **125o** of the cell with protection device **100.**

When the cell **100** is connected in series to other cells, so as to form a so-called "string" (as shown in **Figure 2**), the input terminal **125i** of the cell is connected to an output terminal of the preceding cell in the string (or, if the cell considered is the first of the string, to an input terminal of the string), while the output terminal **125o** is connected to an input terminal of the next cell in the string (or, if the considered cell is the last of the string, to an output terminal of the same string).

In particular, the current switch **120** is responsive to a voltage value **Vc** that, in the operation, develops between the terminals **125i** and **125o** of the cell 100: when the voltage value **Vc** is equal to or greater than a predetermined threshold value (for example, this happens when the cell **100** is arranged in a string of cells exposed to the radiation - for example solar radiation, in general electromagnetic radiation in a specific spectrum range - and the photovoltaic conversion unit **105** is sufficiently illuminated), the current switch **120** connects the emitter terminal **105e** of the photovoltaic conversion unit to the input terminal **120i** of the cell **100** (**Figure 1A),** so that the photovoltaic conversion unit **105** results electrically connected to the input and output terminals **125i, 125o** (accordingly, when the cell **100** is connected in string with other cells, the respective photovoltaic conversion unit **105** results electrically connected to the string). Vice versa, when the voltage value **Vc** falls below the predetermined threshold value (for example, this happens when the cell **100** is arranged in a string of photovoltaic cells that are exposed to radiation, but the conversion unit **105** of the cell under consideration is not sufficiently illuminated), the current switch **120** connects the first terminal **110a** of the bypass path **110** to the input terminal **120i** of the cell **100 (Figure 1B);** in such conditions, the photovoltaic conversion unit **105** is substantially disconnected from the input/output terminals **125i/125o** of the cell **100**, between which the bypass path **110** (with the related impedance **115**) results instead connected (therefore, in the case the cell **100** belongs to a string, the respective photovoltaic conversion unit **105** is disconnected from the string, and is substantially isolated, while the bypass path **110** is connected to the other cells of the string).

It is observed that although in the shown embodiment the controlled device **120**, for example the current switch, is depicted as associated to the emitter terminal **105c** of the photovoltaic conversion unit **105**, this is not to be intended as a limitation, because the controlled device might as well be associated to the base terminal **105b** of the photovoltaic conversion unit **105**, or even two of such devices might be provided for, for example two switches, one associated to the emitter terminal **105e** and one to the base terminal **105b** of the photovoltaic conversion unit **105**.

In a further alternative, the controlled device **120** might be formed of a switch, inserted in the bypass path **110,** the switch, being responsive to the voltage value **Vc** between the two terminals **125i** and **125o,** activates (closing the electric circuit) when the voltage across the cell falls below a predetermined threshold (as occurs for example when the cell, inserted in a string, is in shadow, being insufficiently illuminated with respect to the other cells of the string), so as to divert into the bypass path the current that possibly flow between the input/output terminals **125i/125o** of the cell **100,** without forcing the photovoltaic conversion unit **105** to be brought into so deep reverse bias conditions to allow the establishment of those multiplication/breakdown phenomena that allow the flow of the current. In this case, the photovoltaic conversion unit is short-circuited (that is, its base and emitter terminals **105b, 105e** are short-circuited) by the bypass path, rather than being disconnected, insulated from the other cells of the string.

The controlled device **120** and the bypass path **110** form a protection device for the photovoltaic conversion unit **105** against possible damages deriving from the operation thereof in conditions of reverse biasing, that may occur for example when, as already described in the foregoing and as schematically shown in Figure 2, a plurality ofphotovoltaic cells **100a, 100b,..., 100k,..., 100n** are electrically connected in series, to form a string of cells **200**, like for example in a solar panel of the type that powers satellites. Let for example be assumed that all cells of the string **200** are sufficiently illuminated by radiation, except the cell **100k,** that is in shadow, and thus insufficiently illuminated. In the illuminated cells **100a, 100b,..., 100n** the respective controlled device **120** is in a position **(Figure 1A)** such as to activate the current path in which the photovoltaic conversion unit **105** of those cells is inserted. The photovoltaic conversion units determine the flow of a current **Iph** between the input and the output terminals **200i** and **200o** of the string **200** (between which a voltage develops). It is observed that, with the adopted convention (arrows verses), the current value **Iph** is negative. The current **Iph** is an inverse current for the photovoltaic conversion units **105** of the individual cells, therefore, should a protection device not be provided for the cell **100k** in shadow, this last would be forced to go into reverse biasing conditions (the voltage value across this cell being negative), so as to be able to sustain the flow of the current **Iph**. This could cause damages to the photovoltaic conversion unit **105** of the cell in shadow, as described in the introductory part of the present description. Thanks to the provision of the above described protection device, instead, the controlled device **120,** upon detection through the voltage value **Vc** at the cell **100k** that the latter is shadow with respect to other cells, is switched to the bypass path **110**, therefore the photovoltaic conversion unit **105** is insulated from the other cells (or, in alternative, short-circuited by the bypass path). Thus, the string current **Iph** does not have to flow through the photovoltaic conversion unit **105**, which is therefore not forced to go into reverse biasing conditions; on the contrary, the string current may flow freely through the bypass path **110.** In other words, in certain operating conditions, such as for example in the case in which the cell is inserted in a string of cells, the controlled device **120** provided in the protection device of the cell, is as a device responsive to the illumination conditions of the cell **100** (with respect to the other cells of the string).

In such a way, avoiding that the photovoltaic conversion unit is forced to work in reverse bias conditions, the risk of possible damages of the photovoltaic cell, possibly irreversible, is eliminated.

Moreover, having care that the impedance **115** of the bypass path **110** is kept properly low, it is possible to reduce the overall voltage loss across the string; in fact, differently from the known solutions, which calls for using bypass diodes (having intervention thresholds of about some Volts), the protection device according to the present embodiment of the invention introduces a voltage drop equal to the product of the string current **Iph** multiplied by (the resistive component of the) the impedance **115** of the bypass path.

The protection device described above, and in particular the controlled device **120**, can be implemented in various way; in the following, a possible implementation will be disclosed, having a merely exemplary and non-limitative character.

In particular, referring to **Figure 3**, the protection device includes a transistor, in particular a Field Effect Transistor (FET) **300,** for example of the junction type (Junction FET or JFET), or of the Schottky type, in particular, but not limitatively, a P channel FET. The FET **300** has a first terminal **300s** (for example, the source terminal) connected to the emitter terminal **105e** of the photovoltaic conversion unit, a second terminal **300d** (for example, the drain terminal) connected to the base terminal **105b** of the photovoltaic conversion unit **105** and a gate terminal **300g** connected to the terminals **105b** and **105e** through a suitable biasing network, schematically represented as two lumped impedance elements **305a, 305b** (in particular, two resistors).

When the cell is illuminated, the voltage value **Vc** between the terminals **125i** and **125o** of the cell, equal to the voltage that develops across the photovoltaic conversion unit **105** or photovoltaic voltage Vph (for example, about 1V), biases the gate terminal **300g** to a voltage whose value is determined by the partition between the biasing network elements **305a** and **305b;** these two biasing network elements are such that the difference between the voltage at the gate terminal **300g** and at drain terminal **300d** of the FET **300** is such as to substantially keep the conductive channel of the FET **300** closed; in these conditions, the FET **300** is off, and, in the case in which the cell 100 is inserted in a string of cells, as in the example of **Figure 2**, the string current **Iph** flows through the photovoltaic conversion unit **105** (that contributes with its photovoltaic voltage Vph to the total voltage of the solar panel).

When the cell is at least partially in shadow, thus insufficiently illuminated, and it is connected in string with other illuminated solar cells, these illuminated solar cells force the string current **Iph** to flow through the cell in shadow. In order to sustain the flow of such a current, the cell in shadow should go into reverse bias conditions: the voltage across the cell decreases with respect to the photovoltaic voltage value Vph. By voltage partition, the voltage at the gate terminal **300g** of the FET **300** is intermediate between the voltage at the emitter terminal **105e** and the voltage at the base terminal **105b** of the photovoltaic conversion unit **105**. When, due to the decrease of the voltage across the cell, the voltage difference between the drain terminal **300d** and the gate terminal **300g** reaches the activation threshold of the FET **300** (for example, about 0.5V), the latter switches on, the conductive channel is formed between the first and the second terminal **300d** and **300s** and the string current **Iph** may therefore start to flow through the FET **300**, without necessity that the photovoltaic conversion unit **105** goes into so deep reverse bias conditions to allow the establishment of avalanche multiplication phenomena such as to allow the passage of the string current **Iph**; in other words, thanks to the provision of the protection device, the photovoltaic conversion unit **105** is never forced to operate in reverse bias conditions.

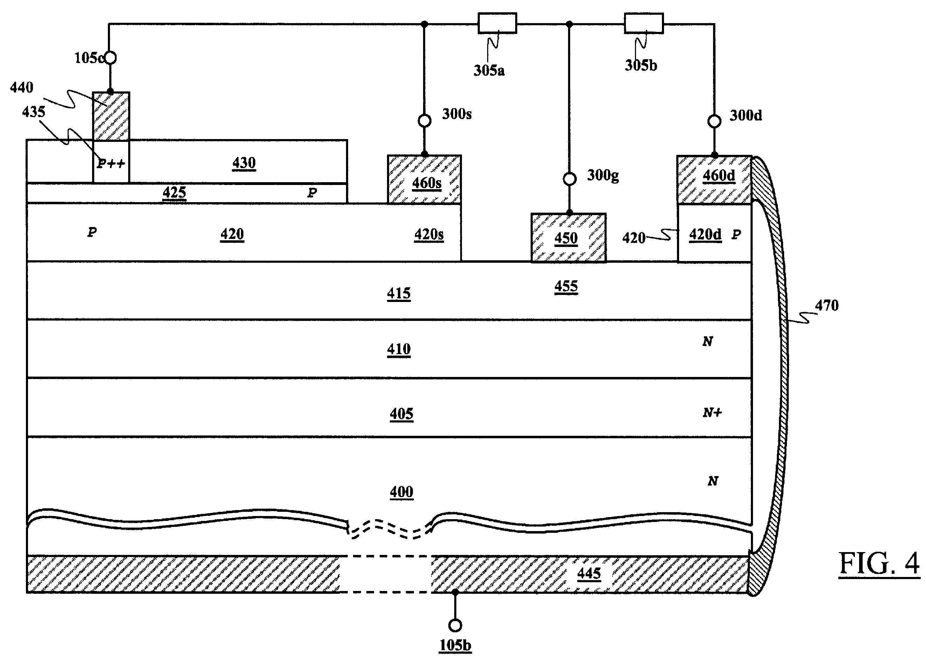

The protection device described above may be realized using discrete components or, preferably, in monolithic way with the photovoltaic conversion unit **105;** an example of cell integrating the protection device is represented in **Figure 4,** showing a cross-sectional view of a *PN* type single-junction cell.

On a semiconductor material substrate **400,** for example of doped Ge, of a first conductivity type, for example *N* type, a layer **405** referred to as "buffer" is formed, typically by means of epitaxy, for example a heavily doped GaAs layer of the first conductivity type, in the example the *N* type; for example, the buffer layer **405** has a dopant concentration ranging from 1*10¹⁸ cm⁻³ to 5*10¹⁸ cm⁻³.

On the buffer layer **405,** a layer **410** called "base" is in turn formed, for example a doped GaAs layer of the first conductivity type, in the example of *N* type; for example, the base layer **410** has a dopant concentration ranging from 1*10¹⁶ cm⁻³ to 7*10¹⁷ cm⁻³.

On the base layer **410,** a layer **415** called "spacer" is formed, for example a GaAs layer, intentionally not doped. On the spacer layer **415**, a layer **420** called "emitter" is in turn grown, for example a doped GaAs layer of a second conductivity type, in the example the P type; for example, the emitter layer **420** may have a dopant concentration ranging from 5*10¹⁷ cm⁻³ to 5*10¹⁸ cm⁻³.

The emitter layer **420** is subsequently passivated through the deposition of a layer **425** called "window", for example a GaAlAs layer, of the second conductivity type, in the example the *P* type.

On the window layer **425**, an antireflection coating (or ARC) layer **430** is formed, for example formed of one or more oxide layers.

In the ARC layer **430** vias are formed to the underlying window layer **425**, and in said vias a "cap" layer **435** is formed, for example a heavily doped GaAs layer of the second conductivity type, in the example the P type; for example, the layer forming the caps **435** may have a dopant concentration ranging from 2*10¹⁸ cm⁻³ to 2*10¹⁹ cm⁻³.

On the caps **435,** an electric contact metallic grid **440** is formed, for example of gold (Au) or silver (Ag). A similar electric contact **445** is formed on the back of the substrate **400**. The contact **440** constitutes the emitter terminal **105e**, while the contact **445** forms the base terminal **105b** of the photovoltaic conversion unit **105**.

For example, the various material layers over the substrate **400** are grown by epitaxy, for example by means of the typical thin film techniques, such as those included in the class of the chemical deposition techniques in vapour phase, for example the MOCVD already mentioned in the foregoing, or in the class of the techniques of Physical Vapour Deposition (PVD), for example the Metal-Organic PVD (MOPVD), or by means of Molecular Beam Epitaxy (MBE).

The protection device described in connection with **Figure 3** can be realized in monolithic form with the photovoltaic conversion unit **105**, locally removing (by means of selective etch) into the emitter layer **420**, so as to uncover the underlying spacer layer **415**, and forming, in the uncovered region, a Schottky contact to the spacer layer **415**, for example depositing and defining by a suitable selective etch an Au electrode **450,** constituting the gate terminal **300g** of the FET **300.** In the portion of spacer layer **415** under the electrode **450** a channel region **455** of the FET **300** is so formed, in which, under suitable biasing conditions of the gate terminal **300g**, a conductive channel is formed that is adapted to conduct current. Respective portions **420s** and **420d** of the emitter layer **420** at the sides of the channel region **455** form source and drain regions of the FET **300**, and respective electrodes **460s** and **460d** are formed thereon, constituting the source and drain terminals **300s** and **300d** of the FET **300**, respectively. The electrode **460s**, that is the source terminal of the FET **300**, is connected to the metallic grid **440** that constitutes the emitter terminal **105e** of the photovoltaic conversion unit. The electrode **460d**, that is the drain terminal **300d** of the FET **300**, is connected to the contact **445** on the back of the substrate **400**, that is to the base terminal **105b** of the photovoltaic conversion unit **105**, as schematically shown in drawing by an electric connection ("shunt") **470**, for example obtainable through a deep etch, down to the layer **400**, and subsequent metallization.

The cell with protection device according to the embodiment herein described, does not use bypass diodes back-connected to the photovoltaic conversion unit, and, in addition to guaranteeing that the photovoltaic conversion unit is not forced to operate in reverse bias conditions, it is particularly advantageous from the viewpoint of the voltage loss that is experienced if the cell, in a string of other cells, is in shadow; in this case , the voltage drop across the cell terminals is low, and substantially corresponds to the product of the string current by the resistance of the bypass current path **110**, for example, the "on" resistance of the FET **300**; the Applicant has estimated that, having care of making the bypass path **110** in such a way that it has a sufficiently low impedance, for example realizing the FET **300** so that it has a low channel resistance, such a voltage drop may be of about 0.5V.

Let it be assumed, by way of example, to have a string of **100** cells, with single-junction photovoltaic conversion units. If all the **100** cells are perfectly illuminated, the output voltage of the string is equal to 100V. Now, let it be assumed that 10 out of the 100 cells are in shadow. The 90 illuminated cells contribute as a whole to the output voltage with 90V; therefore, the output voltage of the string will be equal to 90V-5V=85V; this output voltage is particularly high with respect to those obtainable, in same conditions, with the known solutions. In particular, with cells protected by bypass diodes, the output voltage would be approximately equal to 80V, in the case discrete external diodes are used, and approximately of 70V in the case of integrated or monolithic diodes; in absence of bypass diodes, the output voltage would be even lower, approximately equal to 40V, because 50V out of 90V produced by the illuminated cells would be lost for reverse biasing the cells in shadow.

Thanks to this, the electric power provided by a solar panel is significantly improved: the voltage loss due to the protection systems of the cells, falls from about 200% of the voltage drop due to the operation in shadow (that is, photovoltaic cell that does not contribute), that is experienced using the protection techniques known in the art currently (monolithic bypass diodes), to 50% in the case of use of the solution according to the described embodiment of the invention.

Therefore, the cell according to the present invention is particularly adapted to those applications in which the phenomenon of partial shading of the solar panels is frequent, such as in space applications, in particular on board of satellites; the increase of electric power under partial shading conditions allows limiting or even eliminating the use of so-called "redundancy cells", that are normally provided for making up critical operating conditions such as those of partial shading. This allows limiting the cost of the solar panels.

Another considerable advantage of the solution according to the described embodiment of the present invention is due to the fact that the bypass path of the photovoltaic conversion unit which is a bi-directional path, so it allows the passage of current both in a direction and in the opposite one (and not only in one direction, as in the case of the known protection devices, using bypass diodes). In particular, the bypass path allows the passage of the string current when the cell is in the so-called open circuit, a condition that for example takes place in consequence to internal cell breakings, or to the detachment of the interconnector. The open circuit is one of the most serious problems that appears on a photovoltaic panel, since the string of cells that suffers from the presence of one (or more) cell in open circuit does not supply current; since a string of photovoltaic cells is usually connected in parallel to other similar strings, which are connected in parallel to a so-called "bus", the string in which there is an open-circuit cell is biased at the so-called "bus" voltage by the other strings. Adopting a protection device according to the present invention, that allows the passage of current bidirectionally, that is in the two directions, the cell suffering from the open circuit is short-circuited by the respective protection device. In fact, at the beginning of the breaking, even the cells not affected by the open circuit problems are brought into open circuit conditions. The open circuit voltage is higher than the normal operation voltage of about 10%. Therefore, a string comprising more than ten cells is sufficient to bring to zero the voltage across the cell suffering of open circuit failure, and therefore to cause the controlled device 120 switch onto the bypass path. The string affected by the open circuit will therefore continue to supply current to the bus, even if to a lesser extent compared to the normal operation.

The cell **100** with integrated protection device, for example of the type shown in **Figure 4**, does not therefore require that the user takes particular precautions as far its protection against possible damages from the reverse bias operation is concerned, since the cell is intrinsically protected.

It is observed that although in **Figure 4** reference has been made to a photovoltaic single-junction cell, nothing excludes that the invention is applied to multi-junction cells, for example to three superimposed elementary cells.

It is underlined that, although in the embodiment described reference has been made by way of example to a Schottky junction FET, this is not to be intended as a limitation; other equivalent devices can be used, such as JFETs, MOSFETs, MESFETs, and more generally any electronic device with a conductive channel that can be switched off selectively (emptied of charge carriers), in particular a three terminals device.

As mentioned in the foregoing, in certain operating conditions, such as for example in the case in which the cell is inserted in a string of cells, the controlled device, provided in the protection device of the cell, is responsive to the illumination conditions of the cell (with respect to the other cells of the string); in other words, the controlled device, adapted to activate the bypass path bypassing the photovoltaic conversion unit, may be a device responsive to (a control signal indicative of) the operating conditions of the photovoltaic conversion unit. For example, although in the examples provided in the previous description the controlled device is responsive to a control signal indicative of the voltage at the terminals of the photovoltaic conversion unit, in alternative embodiments of the invention the control signal may be indicative of a current flowing through the photovoltaic conversion unit.

## Claims

1. A photovoltaic cell, in particular a solar cell, including a first **(125i)** and a second terminal **(125o)** and, between said first and second terminals, at least one photovoltaic conversion unit **(105)** and a protection device **(110,120)** of the photovoltaic conversion unit, the protection device including a conductive path (**110**) in bypass to the photovoltaic conversion unit and an activation device of the conductive path,
**characterized in that** said activation device includes at least one controlled device (120;300) adapted to establish a current path in bypass between said first and second terminals through the conductive path in bypass, said controlled device being responsive to a control signal indicative of an operating condition of the photovoltaic conversion unit.

2. The photovoltaic cell according to claim 1, in which said control signal is indicative of a voltage value between said first and second terminals.

3. The photovoltaic cell according to claim 2, in which said current path in bypass is a bi-directional current path.

4. The photovoltaic cell according to claim 2 or 3, in which a voltage value, between the first and second terminals, of a first sign with respect to a preset threshold value determines the deactivation of the conductive path in bypass, whereas a voltage value, between the first and second terminal, of a second sign with respect to the threshold value causes the activation device to activate the conductive path in bypass.

5. The photovoltaic cell according to claim 4, in which said threshold voltage is such that the conductive path in bypass is established before the voltage between the first and the second terminal reaches a breakdown voltage value of the photovoltaic conversion unit, preferably before the photovoltaic conversion unit enters in reverse bias.

6. The photovoltaic cell according to any one of the claims from 2 to 5, in which said activation device includes an electronic device **(300)** with a first and a second electrode **(300s,300d),** a control electrode **(300g)** adapted to receive said control signal, and a conductive channel adapted to be selectively established between said first and second electrode responsive to the control signal.

7. The photovoltaic cell according to claim 6, in which the electronic device includes a Field Effect Transistor (FET).

8. The photovoltaic cell according to claim 7, in which said FET is selected in the group comprising a Schottky junction FET, a Junction FET (JFET), a MESFET, a MOSFET.

9. The photovoltaic cell according to any one of claims from 6 to 8, in which when the conductive path in bypass is activated, a voltage drop between said first and second terminal mainly depends on a resistance of said conductive channel.

10. The photovoltaic cell according to any one of the claims from 2 to 9, in which the conductive path in bypass and the activation device are realized in monolithic form with the photovoltaic conversion unit.

11. The photovoltaic cell according to any one of the claims from 2 to 10, in which the conductive path in bypass and the activation device are realized as discrete components, adapted to be associated to the photovoltaic conversion unit.

12. A photovoltaic conversion structure, including at least one string (200) of photovoltaic cells, said string including in turn at least two photovoltaic cells **(100a,..., 100n)** electrically connected in series, in which said photovoltaic cells are realized according to any one of the preceding claims.

13. The photovoltaic conversion structure according to claim 12, in which the at least one string includes at least two strings connected in parallel.

14. A solar panel including at least one photovoltaic conversion structure according to claim 12 or 13.

15. A method of protecting a photovoltaic cell including a first and a second electric terminal and a photovoltaic conversion unit (105) between said first and second terminals, the method including:
providing a selectively activatable conductive path between said first and second terminals, in bypass to the photovoltaic conversion unit; and
activating the conductive path in bypass to establish a current path in bypass between said first and second terminals,
**characterized in that**
said activating the conductive path in bypass includes conditioning the activation of the path to an control signal indicative of an operating condition of the photovoltaic conversion unit.

16. The method according to claim 15, in which said activating the conductive path in bypass includes conditioning the activation of the path to an control signal indicative of a voltage value between said first and second terminals.
